# EUROPEAN PATENT SPECIFICATION

(11) **EP 3 316 331 B1**
(45) Date of publication and mention of the grant of the patent: **02.12.2020**
(21) Application number: 17198792.8
(22) Date of filing: 27.10.2017
(51) Int. Cl.: H01L 51/52, H01L 27/32

(54) **DISPLAY SUBSTRATE, METHOD FOR MANUFACTURING THE SAME AND ELECTRONIC APPARATUS**
ANZEIGESUBSTRAT, VERFAHREN ZUR HERSTELLUNG DAVON UND ELEKTRONISCHE VORRICHTUNG DAMIT
SUBSTRAT DE DISPOSITF D'AFFICHAGE, SON PROCÉDÉ DE FABRICATION ET APPAREIL ÉLECTRONIQUE AVEC CELUI-CI

(30) Priority: 27.10.2016 CN 201610957966
(43) Date of publication of application: 02.05.2018
(73) Proprietor: Beijing Xiaomi Mobile Software Co., Ltd., Beijing 100085 (CN)
(72) Inventor: LIU, Anyu, Beijing 100085 (CN)
(74) Representative: dompatent von Kreisler Selting Werner - Partnerschaft von Patent- und Rechtsanwälten mbB

(56) References cited:
- EP-A1- 1 986 324
- WO-A1-2015/186266
- CN-A- 101 894 856
- CN-A- 104 881 179
- CN-A- 105 518 863
- JP-A- H09 251 820

## Description

### TECHNICAL FIELD

The present disclosure generally relates to the field of terminal technology, and more particularly, to a display substrate, a method for manufacturing the same and an electronic apparatus.

### BACKGROUND

As touch functions are applied more and more widely, structures of touch electrodes for recognizing the touch operation are also becoming more and more diversified, so as to be provided at different positions of a display device. However, currently, a majority of the touch electrodes are still manufactured independently of the display device, and the level of the touch electrodes integrating with the display device is low, which results in a cumbersome technological process and large product volume.

CN 105 518 863 A, CN 104 881 179 A, WO 2015/186266 A1, EP 1 986 324 A1 and JP H09 251820 A disclose OLED displays integrated with a touch display.

### SUMMARY

The present disclosure provides a display substrate, a method for manufacturing the same and an electronic apparatus, to overcome shortcomings in the related art.

According to a first aspect of embodiments of the present disclosure, there is provided a display substrate in accordance with claim 1.

Optionally, the display substrate further includes:
an insulating layer, disposed between the touch electrode layer and a layer structure adjacent to the touch electrode layer.

Optionally, the touch electrode layer is a self-induction capacitor.

According to a second aspect of embodiments of the present disclosure, there is provided a method for manufacturing a display substrate in accordance with claim 4.

Optionally, the above manufacturing method further includes:

forming an insulating layer between the touch electrode layer and a layer structure adjacent to the touch electrode layer.

Optionally, the touch electrode layer is a self-induction capacitor.

According to a third aspect of embodiments of the present disclosure, there is provided an electronic apparatus in accordance with claim 7.

The technical scheme according to embodiments of the present disclosure may have the following beneficial effects.

Through the above embodiments of the present disclosure, a touch electrode layer is formed in the organic light emitting layer, which may increase the integration level of the display substrate. In addition, since an area of the organic light emitting layer may be set larger, or even the organic light emitting layer may be disposed directly over the thin film transistor and thus a touch electrode layer is formed in the organic light emitting layer, which facilitates setting the touch electrode layer to be larger, and further senses touch signals in a larger range.

It is to be understood that both the foregoing general description and the following detailed description are exemplary and explanatory only and are not restrictive of the present disclosure.

### BRIEF DESCRIPTION OF THE DRAWINGS

The accompanying drawings, which are incorporated in and constitute a part of this specification, illustrate embodiments consistent with the present disclosure and, together with the description, serve to explain the principles of the present disclosure.
Fig. 1 is a schematic diagram showing a display substrate according to an exemplary embodiment.
Fig. 2 is a schematic diagram showing an organic light emitting layer according to an exemplary embodiment.
Fig. 3 is a schematic diagram showing an organic light emitting layer according to another exemplary embodiment.
Fig. 4 is a flow chart showing a method for manufacturing a display substrate according to an exemplary embodiment.
Fig. 5 is a flow chart showing a method for manufacturing a display substrate according to another exemplary embodiment.
Fig. 6 is a flow chart showing a method for manufacturing a display substrate according to yet another exemplary embodiment.
Fig. 7 is a schematic diagram showing a display device according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present disclosure. Instead, they are merely examples of devices and methods consistent with aspects related to the present disclosure as recited in the appended claims.

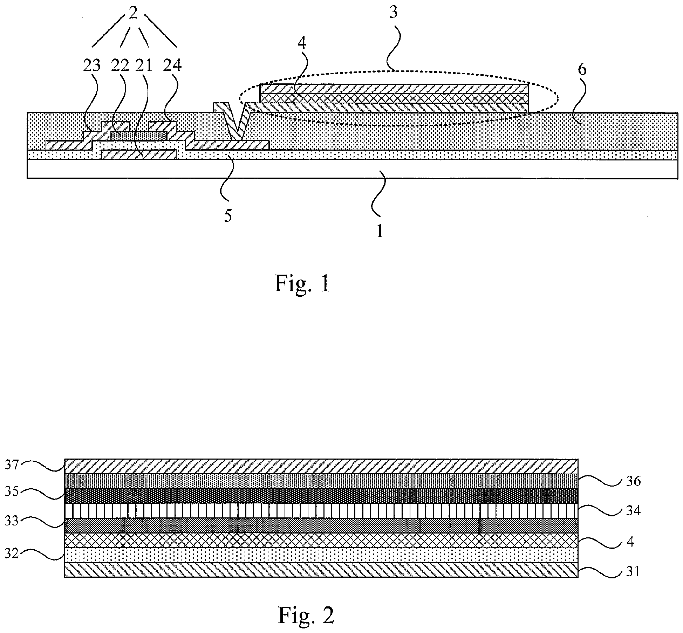

Fig. 1 is a schematic diagram showing a display substrate according to an exemplary embodiment. As shown in Fig. 1, the display substrate includes: a base 1, a thin film transistor 2, an organic light emitting layer 3 and a touch electrode layer 4.

In an embodiment, the material of the base may be glass. When the display substrate is applied to a flexible display device, the material of the base may be flexible resin.

The thin film transistor 2 is formed on a side of the base 1.

In an embodiment, as shown in Fig. 2, the thin film transistor 2 may include structures such as a gate electrode 21, an active layer 22, a source electrode 23 and a drain electrode 24. A gate insulating layer 5 may also be provided between the gate electrode 21 and the active layer 22.

The organic light emitting layer 3 is formed on a side of the thin film transistor 2 away from the base 1.

In an embodiment, the organic light emitting layer being formed on a side of the thin film transistor away from the base means that the organic light emitting layer is formed after the thin film transistor is formed. A passivation layer 6 may be provided between the organic light emitting layer 3 and the thin film transistor 2. The organic light emitting layer 3 is electrically connected to the thin film transistor through a via hole in the passivation layer 6. In the embodiment, the thin film transistor may be formed by a patterning process, and the organic light emitting layer may be formed by a vapor deposition process.

It should be noted that, in Fig. 1, the relationship between sizes and positions of the organic light emitting layer and the thin film transistor is only an example, which may be adjusted as needed. For example, an area of the organic light emitting layer is increased, so that the organic light emitting layer also lies above the thin film transistor. In addition, a pixel defining layer may also be provided between the sub-pixels constituted by the organic light emitting layer, which will not be repeated in the present disclosure.

The touch electrode layer 4 is formed in the organic light emitting layer 3.

In an embodiment, the organic light emitting layer may include a multi-layer structure, and the touching electrode layer may be formed between two adjacent layers among the multi-layer structure. In the embodiment, the touch electrode layer may be formed by a patterning process, and a wiring electrically connected to the touch electrode layer may be formed in the display substrate, which will not be repeated herein.

In an embodiment, a touch electrode layer is formed in the organic light emitting layer, which may increase the integration level of the display substrate. In addition, since an area of the organic light emitting layer may be set to be larger, or even the organic light emitting layer may be disposed directly over the thin film transistor and thus a touch electrode layer is formed in the organic light emitting layer, which facilitates setting a the touch electrode layer with a larger size, and further senses touch signals in a larger range.

Fig. 2 is a schematic diagram showing an organic light emitting layer according to an exemplary embodiment. The organic light emitting layer includes:
an anode layer 31, formed on a side of the thin film transistor 2 away from the base 1;
a hole injection layer 32, formed on a side of the anode layer 31 away from the thin film transistor 2;
a hole transport layer 33, formed on a side of the hole injection layer 32 away from the anode layer 31;
an organic material layer 34, formed on a side of the hole transport layer 33 away from the hole injection layer 32;
an electron transport layer 35, formed on a side of the organic material layer 34 away from the hole transport layer 33;
an electron injection layer 36, formed on a side of the electron transport layer 35 away from the organic material layer 34; and
a cathode layer 37, formed on a side of the electron injection layer 36 away from the electron transport layer 35.

The touch electrode layer is formed between the hole injection layer and the hole transport layer, or between the hole transport layer and the organic material layer, or between the organic material layer and the electron transport layer, or between the electron transport layer and the electron injection layer.

In an embodiment, as shown in Fig. 2, the touch electrode layer 4 may be disposed between the hole injection layer 32 and the hole transport layer 33. In the embodiment, a positive voltage may be applied to the anode layer, and a negative voltage may be applied to the cathode layer, thus forming a current flowing from the anode layer to the cathode layer. Electrons from the cathode layer sequentially pass through the electron injection layer, the electron transport layer, the organic material layer, the hole transport layer, the hole injection layer, reach the anode layer, and excite the organic material in the organic material layer to emit light when electrons pass through the organic material layer.

In an embodiment, the organic material layers in all of the sub-pixels emit white light when being excited. A color filter, such as a red filter, a green filter and a blue filter, is required to be provided in a substrate arranged corresponding to the display substrate, so that the lights emitted from the sub-pixels corresponding to the filters with different colors are different in color, and thus the light emission color of the corresponding pixel may be changed by adjusting the light emission intensity of the sub-pixel.

In an embodiment, the organic material layers in different sub-pixels emit lights with different colors when being excited, for example, they may emit red light, green light and blue light respectively, so that the lights emitted from different sub-pixels are different in color, and thus the light emission color of the corresponding pixel may be changed by adjusting the light emission intensity of the sub-pixel.

In an embodiment, if a display substrate is applied to a display device of a bottom emission structure, an anode may be formed by transparent conductive material and a cathode may be formed by conductive material with a high reflectivity, so that the light may be emitted from the bottom. If the display substrate is applied to a display device of a top emission structure, a cathode may be formed by transparent conductive material and an anode may be formed by conductive material with a high reflectivity, so that the light may be emitted from the top. In the embodiment, the transparent conductive material may be ITO (indium tin oxide), and the conductive material with a higher reflectivity may be a metal, such as aluminum or silver.

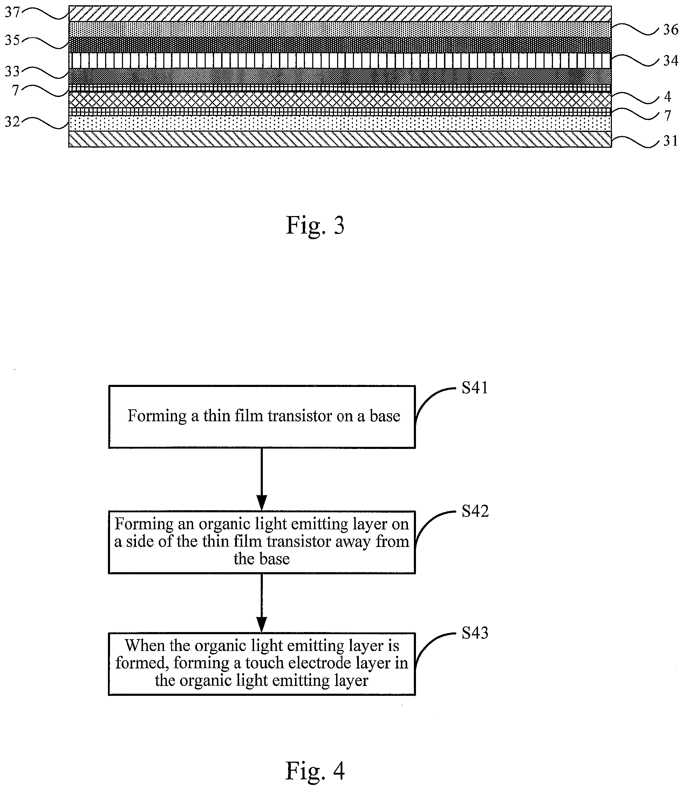

Fig. 3 is a schematic diagram showing an organic light emitting layer according to another exemplary embodiment.

An insulating layer 7 is disposed between the touch electrode layer 4 and a layer structure adjacent to the touch electrode layer 4.

In an embodiment, for example, on the basis of Fig.2, an insulating layer may be provided between the touch electrode layer 4 and the hole injection layer 32, and between the touch electrode layer 4 and the hole transport layer 33. Since there are electrons flowing from the cathode layer to the anode layer in respective layer structures in the organic light emitting layer, and electrons may stay in the layer structure adjacent to the touch electrode layer, thereby touch signals generated by the touch electrode layer may be affected. An insulating layer is provided between the touch electrode layer and a layer structure adjacent thereto, so that the touch electrode layer may be less influenced by other layer structures, thereby the accuracy of sensing touch operation of the touch electrode may be improved.

Optionally, the touch electrode layer is a self-induction capacitor.

In an embodiment, when a user touches the display device where the above display substrate is applied in, the cathode layer will be located between a finger and the touch electrode layer, thereby generating a shielding effect on the touch signal generated by sensing of the touch electrode layer. The intensity of touch signals generated by the self-induction capacitor sensing the touch operation is large, which is more conducive to obtain accurate touch results.

Corresponding to the above embodiments of the display substrate, the present disclosure further provides embodiments of a method for manufacturing a display substrate.

Fig. 4 is a flow chart showing a method for manufacturing a display substrate according to an exemplary embodiment. As shown in Fig. 4, the method includes following steps.

At step S41, a thin film transistor is formed on a base.

At step S42, an organic light emitting layer is formed on a side of the thin film transistor away from the base.

At step S43, when the organic light emitting layer is formed, a touch electrode layer is formed in the organic light emitting layer.

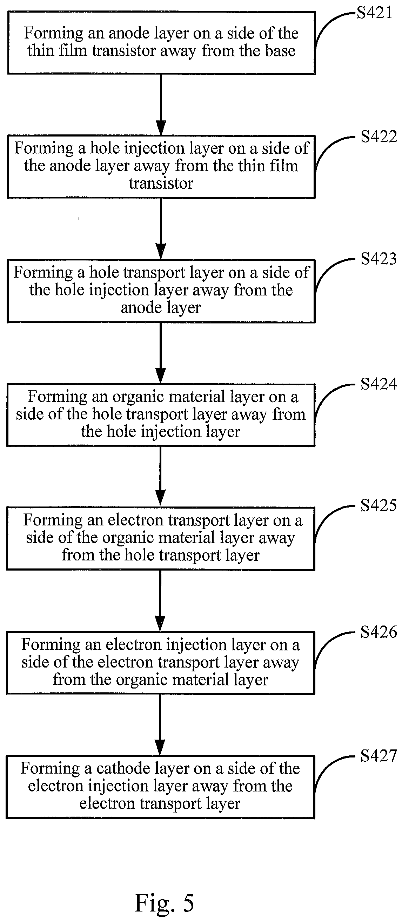

Fig. 5 is a flow chart showing a method for manufacturing a display substrate according to another exemplary embodiment. On the basis of the embodiment as shown in Fig. 4, the forming an organic light emitting layer on a side of the thin film transistor away from the base includes following steps.

At step S421, an anode layer is formed on a side of the thin film transistor away from the base.

At step S422, a hole injection layer is formed on a side of the anode layer away from the thin film transistor.

At step S423, a hole transport layer is formed on a side of the hole injection layer away from the anode layer.

At step S424, an organic material layer is formed on a side of the hole transport layer away from the hole injection layer.

At step S425, an electron transport layer is formed on a side of the organic material layer away from the hole transport layer.

At step S426, an electron injection layer is formed on a side of the electron transport layer away from the organic material layer.

At step S427, a cathode layer is formed on a side of the electron injection layer away from the electron transport layer.

Forming the touch electrode layer in the organic light emitting layer includes:
forming the touch electrode layer between the hole injection layer and the hole transport layer; or
forming the touch electrode layer between the hole transport layer and the organic material layer; or
forming the touch electrode layer between the organic material layer and the electron transport layer; or
forming the touch electrode layer between the electron transport layer and the electron injection layer.

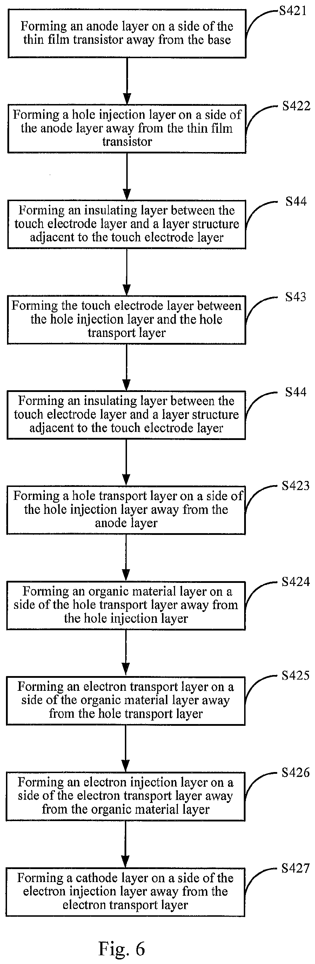

Fig. 6 is a flow chart showing a method for manufacturing a display substrate according to yet another exemplary embodiment. On the basis of the embodiment as shown in Fig. 5, the above manufacturing method further includes:
at step S44, forming an insulating layer between the touch electrode layer and a layer structure adjacent to the touch electrode layer.

It should be noted that, the execution order of the steps in the above-described manufacturing method may be adjusted as needed. For example, step S43 may be performed between step S422 and step S423, and step S44 may be performed between step S422 and step S44, and step S423 and step S44.

Optionally, the touch electrode layer is a self-induction capacitor.

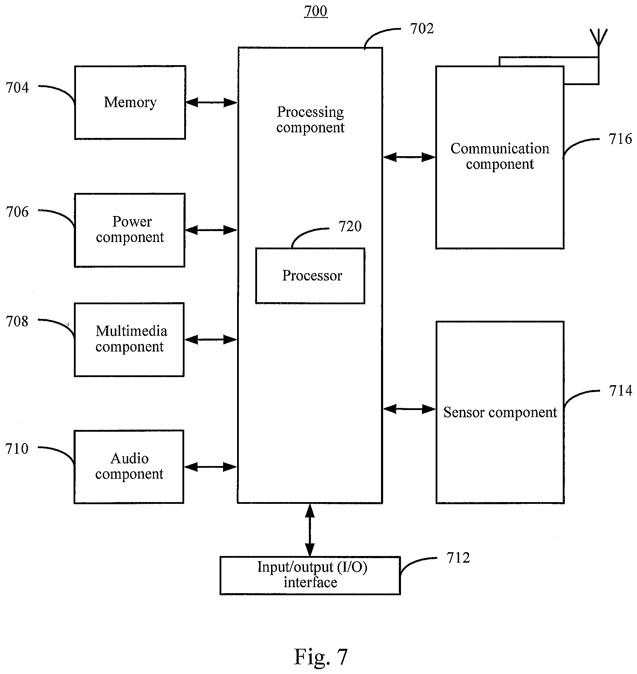

Fig. 7 is a schematic diagram showing a display device 700 according to an exemplary embodiment. For example, the device 700 may be a mobile phone, a computer, a digital broadcast terminal, a messaging device, a gaming console, a tablet, a medical device, exercise equipment, a personal digital assistant, and the like.

Referring to Fig. 7, the device 700 may include one or more of the following components: a processing component 702, a memory 704, a power component 706, a multimedia component 708, an audio component 710, an input/output (I/O) interface 712, a sensor component 714, and a communication component 716.

The processing component 702 typically controls overall operations of the device 700, such as the operations associated with display, telephone calls, data communications, camera operations, and recording operations. The processing component 702 may include one or more processors 720 to execute instructions. Moreover, the processing component 702 may include one or more modules which facilitate the interaction between the processing component 702 and other components. For instance, the processing component 702 may include a multimedia module to facilitate the interaction between the multimedia component 708 and the processing component 702.

The memory 704 is configured to store various types of data to support the operation of the device 700. Examples of such data include instructions for any applications or methods operated on the device 700, contact data, phonebook data, messages, pictures, video, etc. The memory 704 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 706 provides power to various components of the device 700. The power component 706 may include a power management system, one or more power sources, and any other components associated with the generation, management, and distribution of power in the device 700.

The multimedia component 708 includes a screen providing an output interface between the device 700 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 708 includes a front camera and/or a rear camera. The front camera and/or the rear camera may receive an external multimedia datum while the device 700 is in an operation mode, such as a photographing mode or a video mode. Each of the front camera and the rear camera may be a fixed optical lens system or have focus and optical zoom capability.

The audio component 710 is configured to output and/or input audio signals. For example, the audio component 710 includes a microphone ("MIC") configured to receive an external audio signal when the device 700 is in an operation mode, such as a call mode, a recording mode, and a voice recognition mode. The received audio signal may be further stored in the memory 704 or transmitted via the communication component 716. In some embodiments, the audio component 710 further includes a speaker to output audio signals.

The I/O interface 712 provides an interface between the processing component 702 and peripheral interface modules, such as a keyboard, a click wheel, buttons, and the like. The buttons may include, but are not limited to, a home button, a volume button, a starting button, and a locking button.

The sensor component 714 includes one or more sensors to provide status assessments of various aspects of the device 700. For instance, the sensor component 714 may detect an open/closed status of the device 700, relative positioning of components, e.g., the display and the keypad, of the device 700, a change in position of the device 700 or a component of the device 700, a presence or absence of user contact with the device 700, an orientation or an acceleration/deceleration of the device 700, and a change in temperature of the device 700. The sensor component 714 may include a proximity sensor configured to detect the presence of nearby objects without any physical contact. The sensor component 714 may further include a light sensor, such as a CMOS or CCD image sensor, for use in imaging applications. In some embodiments, the sensor component 714 may further include an accelerometer sensor, a gyroscope sensor, a magnetic sensor, a pressure sensor or a temperature sensor.

The communication component 716 is configured to facilitate communication, wired or wirelessly, between the device 700 and other devices. The device 700 may access a wireless network based on a communication standard, such as WiFi, 2G, or 3G, or a combination thereof. In one exemplary embodiment, the communication component 716 receives a broadcast signal or broadcast associated information from an external broadcast management system via a broadcast channel. In one exemplary embodiment, the communication component 716 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the device 700 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components.

In exemplary embodiments, there is further provided a non-transitory computer-readable storage medium including instructions, such as included in the memory 704, executable by the processor 720 in the device 700. For example, the non-transitory computer-readable storage medium may be a ROM, a RAM, a CD-ROM, a magnetic tape, a floppy disc, an optical data storage device, and the like.

## Claims

1. A display substrate, comprising:
a base (1);
a thin film transistor (2), formed on a side of the base (1);
an organic light emitting layer (3), formed on a side of the thin film transistor (2) away from the base (1); and
a touch electrode layer (4), formed in the organic light emitting layer (3)
wherein the organic light emitting layer (3) comprises:
an anode layer (31), formed on a side of the thin film transistor (2) away from the base (1);
a hole injection layer (32), formed on a side of the anode layer (31) away from the thin film transistor (2);
a hole transport layer (33), formed on a side of the hole injection layer (32) away from the anode layer (31);
an organic light emitting material layer (34), formed on a side of the hole transport layer (33) away from the hole injection layer (32);
an electron transport layer (35), formed on a side of the organic light emitting material layer (34) away from the hole transport layer (33);
an electron injection layer (36), formed on a side of the electron transport layer (35) away from the organic light emitting material layer (34); and
a cathode layer (37), formed on a side of the electron injection layer (36) away from the electron transport layer (35) and
**characterized in that** the touch electrode layer (4) is formed between the hole injection layer (32) and the hole transport layer (33), or between the hole transport layer (33) and the organic light emitting material layer (34), or between the organic light emitting material layer (34) and the electron transport layer (35), or between the electron transport layer (35) and the electron injection layer (36).

2. The display substrate of claim 1, further comprising:
an insulating layer (7), disposed between the touch electrode layer (4) and the adjoining hole injection layer or hole transport layer or organic light emitting material layer or electron transport layer or electron injection layer.

3. The display substrate of any one of claims 1 or 2, wherein the touch electrode layer (4) is a self-induction capacitor.

4. A method for manufacturing a display substrate, comprising:
forming (S41) a thin film transistor (2) on a base (1);
forming (S42) an organic light emitting layer (3) on a side of the thin film transistor (2) away from the base (1); and
wherein when the organic light emitting layer (3) is formed, forming (S43) a touch electrode layer (4) in the organic light emitting layer (3)
wherein the forming (S42) an organic light emitting layer (3) on a side of the thin film transistor (2) away from the base (1) comprises:
forming (S421) an anode layer (31) on a side of the thin film transistor (2) away from the base (1);
forming (S422) a hole injection layer (32) on a side of the anode layer (31) away from the thin film transistor (2);
forming (S423) a hole transport layer (33) on a side of the hole injection layer (32) away from the anode layer (31);
forming (S424) an organic light emitting material layer (34) on a side of the hole transport layer (33) away from the hole injection layer (32);
forming (S425) an electron transport layer (35) on a side of the organic light emitting material layer (34) away from the hole transport layer (33);
forming (S426) an electron injection layer (36) on a side of the electron transport layer (35) away from the organic light emitting material layer (34); and
forming (S427) a cathode layer (37) on a side of the electron injection layer (36) away from the electron transport layer (35) and
**characterized in that** forming (S43) the touch electrode layer (4) in the organic light emitting layer (3) comprises:
forming the touch electrode layer (4) between the hole injection layer (32) and the hole transport layer (33); or
forming the touch electrode layer (4) between the hole transport layer (33) and the organic light emitting material layer (34); or
forming the touch electrode layer (4) between the organic light emitting material layer (34) and the electron transport layer (35); or
forming the touch electrode layer (4) between the electron transport layer (35) and the electron injection layer (36).

5. The method of claim 4, further comprising:
forming (S44) an insulating layer (7) between the touch electrode layer (4) and the adjoining hole injection layer or hole transport layer or organic light emitting material layer or electron transport layer or electron injection layer.

6. The method of any one of claims 4 or 5, wherein the touch electrode layer (4) is a self-induction capacitor.

7. An electronic apparatus, comprising:
a processor (720); and
a memory (704) for storing instructions executable by the processor (720),
wherein the electronic apparatus further comprises a display substrate according to any of claims 1 to 3.

## Patentansprüche

1. Display-Substrat, umfassend:
eine Basis (1);
einen Dünnschichttransistor (2), der auf einer Seite der Basis (1) gebildet ist;
eine organische Leuchtschicht (3), die auf einer Seite des Dünnschichttransistors (2), die von der Basis (1) abgewandt ist, gebildet ist;
eine Berührungselektrodenschicht (4), die in der organischen Leuchtschicht (3) gebildet ist;
wobei die organische Leuchtschicht (3) umfasst:
eine Anodenschicht (31), die auf einer Seite des Dünnschichttransistors (2), die von der Basis (1) abgewandt ist, gebildet ist;
eine Lochinjektionsschicht (32), die auf einer Seite der Anodenschicht (31), die von dem Dünnschichttransistor (2) abgewandt ist, gebildet ist;
eine Lochtransportschicht (33), die auf einer Seite der Lochinjektionsschicht (32), die von der Anodenschicht (31) abgewandt ist, gebildet ist;
eine organische Leuchtstoffschicht (34), die auf einer Seite der Lochtransportschicht (33), die von der Lochinjektionsschicht (32) abgewandt ist, gebildet ist;
eine Elektronentransportschicht (35), die auf einer Seite der organischen Leuchtstoffschicht (34), die von der Lochtransportschicht (33) abgewandt ist, gebildet ist;
eine Elektroneninjektionsschicht (36), die auf einer Seite der Elektronentransportschicht (35), die von der organischen Leuchtstoffschicht (34) abgewandt ist, gebildet ist; und
eine Kathodenschicht (37) die auf einer Seite der Elektroneninjektionsschicht (36), die von der Elektronentransportschicht (35) abgewandt ist, gebildet ist;
**dadurch gekennzeichnet, dass** die Berührungselektrodenschicht (4) zwischen der Lochinjektionsschicht (32) und der Lochtransportschicht (33) oder zwischen der Lochtransportschicht (33) und der organischen Leuchtstoffschicht (34) oder zwischen der organischen Leuchtstoffschicht (34) und der Elektronentransportschicht (35) oder zwischen der Elektronentransportschicht (35) und der Elektroneninjektionsschicht (36) gebildet ist.

2. Display-Substrat gemäß Anspruch 1, weiterhin umfassend:
eine Isolationsschicht (7), die sich zwischen der Berührungselektrodenschicht (4) und der daran angrenzenden Lochinjektionsschicht oder Lochtransportschicht oder organischen Leuchtstoffschicht oder Elektronentransportschicht oder Elektroneninjektionsschicht befindet.

3. Display-Substrat gemäß einem der Ansprüche 1 oder 2, wobei die Berührungselektrodenschicht (4) ein Kondensator mit Selbstinduktivität ist.

4. Verfahren zur Herstellung eines Display-Substrats, umfassend:
Bilden (S41) eines Dünnschichttransistors (2) auf einer Basis (1);
Bilden (S42) einer organischen Leuchtschicht (3) auf einer Seite des Dünnschichttransistors (2), die von der Basis (1) abgewandt ist; und
dabei, wenn die organische Leuchtschicht (3) gebildet wird, Bilden (S43) einer Berührungselektrodenschicht (4) in der organischen Leuchtschicht (3);
wobei das Bilden (S42) einer organischen Leuchtschicht (3) auf einer Seite des Dünnschichttransistors (2), die von der Basis (1) abgewandt ist, umfasst:
Bilden (S421) einer Anodenschicht (31) auf einer Seite des Dünnschichttransistors (2), die von der Basis (1) abgewandt ist;
Bilden (S422) einer Lochinjektionsschicht (32) auf einer Seite der Anodenschicht (31), die von dem Dünnschichttransistor (2) abgewandt ist;
Bilden (S423) einer Lochtransportschicht (33) auf einer Seite der Lochinjektionsschicht (32), die von der Anodenschicht (31) abgewandt ist;
Bilden (S424) einer organischen Leuchtstoffschicht (34) auf einer Seite der Lochtransportschicht (33), die von der Lochinjektionsschicht (32) abgewandt ist;
Bilden (S425) einer Elektronentransportschicht (35) auf einer Seite der organischen Leuchtstoffschicht (34), die von der Lochtransportschicht (33) abgewandt ist;
Bilden (S426) einer Elektroneninjektionsschicht (36) auf einer Seite der Elektronentransportschicht (35), die von der organischen Leuchtstoffschicht (34) abgewandt ist; und
Bilden (S427) einer Kathodenschicht (37) auf einer Seite der Elektroneninjektionsschicht (36), die von der Elektronentransportschicht (35) abgewandt ist;
**dadurch gekennzeichnet, dass** das Bilden (S43) der Berührungselektrodenschicht (4) in der organischen Leuchtschicht (3) umfasst:
Bilden der Berührungselektrodenschicht (4) zwischen der Lochinjektionsschicht (32) und der Lochtransportschicht (33); oder
Bilden der Berührungselektrodenschicht (4) zwischen der Lochtransportschicht (33) und der organischen Leuchtstoffschicht (34); oder
Bilden der Berührungselektrodenschicht (4) zwischen der organischen Leuchtstoffschicht (34) und der Elektronentransportschicht (35); oder
Bilden der Berührungselektrodenschicht (4) zwischen der Elektronentransportschicht (35) und der Elektroneninjektionsschicht (36).

5. Verfahren gemäß Anspruch 4, weiterhin umfassend:
Bilden (S44) einer Isolationsschicht (7) zwischen der Berührungselektrodenschicht (4) und der daran angrenzenden Lochinjektionsschicht oder Lochtransportschicht oder organischen Leuchtstoffschicht oder Elektronentransportschicht oder Elektroneninjektionsschicht.

6. Verfahren gemäß einem der Ansprüche 4 oder 5, wobei die Berührungselektrodenschicht (4) ein Kondensator mit Selbstinduktivität ist.

7. Elektronische Vorrichtung, umfassend:
einen Prozessor (720); und
einen Speicher (704) zum Speichern von Anweisungen, die durch den Prozessor (720) ausführbar sind;
wobei die elektronische Vorrichtung weiterhin ein Display-Substrat gemäß einem der Ansprüche 1 bis 3 umfasst.

## Revendications

1. Substrat d'affichage, comprenant :
une base (1),
un transistor en couches minces (2) formé sur un côté de la base (1),
une couche électroluminescente organique (3) formée sur un côté du transistor en couches minces (2) détourné de la base (1), et
une couche d'électrode tactile (4) formée dans la couche électroluminescente organique (3),
où ladite couche électroluminescente organique (3) comprend :
une couche d'anode (31) formée sur un côté du transistor en couches minces (2) détourné de la base (1),
une couche d'injection de trous (32) formée sur un côté de la couche d'anode (31) détourné du transistor en couches minces (2),
une couche de transport de trous (33) formée sur un côté de la couche d'injection de trous (32) détourné de la couche d'anode (31),
une couche de matériau électroluminescent organique (34) formée sur un côté de la couche de transport de trous (33) détourné de la couche d'injection de trous (32),
une couche de transport d'électrons (35) formée sur un côté de la couche de matériau électroluminescent organique (34) détourné de la couche de transport de trous (33),
une couche d'injection d'électrons (36) formée sur un côté de la couche de transport d'électrons (35) détourné de la couche de matériau électroluminescent organique (34), et
une couche de cathode (37) formée sur un côté de la couche d'injection d'électrons (36) détourné de la couche de transport d'électrons (35),
**caractérisé en ce que** ladite couche d'électrode tactile (4) est formée entre ladite couche d'injection de trous (32) et ladite couche de transport de trous (33), ou entre ladite couche de transport de trous (33) et ladite couche de matériau électroluminescent organique (34), ou entre ladite couche de matériau électroluminescent organique (34) et ladite couche de transport d'électrons (35), ou entre ladite couche de transport d'électrons (35) et ladite couche d'injection d'électrons (36).

2. Substrat d'affichage selon la revendication 1, comprenant en outre :
une couche isolante (7) disposée entre ladite couche d'électrode tactile (4) et la couche adjacente, qui est ladite couche d'injection de trous, ou ladite couche de transport de trous, ou ladite couche de matériau électroluminescent organique, ou ladite couche de transport d'électrons, ou ladite couche d'injection d'électrons.

3. Substrat d'affichage selon l'une des revendications 1 ou 2, dans lequel ladite couche d'électrode tactile (4) est un condensateur à auto-inductance.

4. Procédé de fabrication d'un substrat d'affichage, comprenant les étapes consistant à :
former (S41) un transistor en couches minces (2) sur une base (1),
former (S42) une couche électroluminescente organique (3) sur un côté du transistor en couches minces (2) détourné de la base (1), et
quand la couche électroluminescente organique (3) est formée, former (S43) une couche d'électrode tactile (4) dans la couche électroluminescente organique (3),
dans lequel ladite étape consistant à former (S42) une couche électroluminescente organique (3) sur un côté du transistor en couches minces (2) détourné de la base (1) comprend les étapes consistant à :
former (S421) une couche d'anode (31) sur un côté du transistor en couches minces (2) détourné de la base (1),
former (S422) une couche d'injection de trous (32) sur un côté de la couche d'anode (31) détourné du transistor en couches minces (2),
former (S423) une couche de transport de trous (33) sur un côté de la couche d'injection de trous (32) détourné de la couche d'anode (31),
former (S424) une couche de matériau électroluminescent organique (34) sur un côté de la couche de transport de trous (33) détourné de la couche d'injection de trous (32),
former (S425) une couche de transport d'électrons (35) sur un côté de la couche de matériau électroluminescent organique (34) détourné de la couche de transport de trous (33),
former (S426) une couche d'injection d'électrons (36) sur un côté de la couche de transport d'électrons (35) détourné de la couche de matériau électroluminescent organique (34), et
former (S427) une couche de cathode (37) sur un côté de la couche d'injection d'électrons (36) détourné de la couche de transport d'électrons (35), et
**caractérisé en ce que** ladite étape consistant à former (S43) une couche d'électrode tactile (4) dans la couche électroluminescente organique (3) comprend les étapes consistant à :
former la couche d'électrode tactile (4) entre la couche d'injection de trous (32) et la couche de transport de trous (33), ou
former la couche d'électrode tactile (4) entre la couche de transport de trous (33) et la couche de matériau électroluminescent organique (34), ou
former la couche d'électrode tactile (4) entre la couche de matériau électroluminescent organique (34) et la couche de transport d'électrons (35), ou
former la couche d'électrode tactile (4) entre la couche de transport d'électrons (35) et la couche d'injection d'électrons (36).

5. Procédé selon la revendication 4, comprenant en outre :
l'étape consistant à former (S44) une couche isolante (7) entre ladite couche d'électrode tactile (4) et la couche adjacente, qui est ladite couche d'injection de trous, ou ladite couche de transport de trous, ou ladite couche de matériau électroluminescent organique, ou ladite couche de transport d'électrons, ou ladite couche d'injection d'électrons.

6. Procédé selon l'une des revendications 4 ou 5, dans lequel ladite couche d'électrode tactile (4) est un condensateur à auto-inductance.

7. Dispositif électronique, comprenant :
un processeur (720), et
une mémoire (704) pour stocker des instructions exécutables par le processeur (720),
dans lequel ledit dispositif électronique comprend en outre un substrat d'affichage selon l'une quelconque des revendications 1 à 3.
